# EUROPÄISCHE PATENTANMELDUNG

(11) **EP 1 139 709 A2**
(43) Veröffentlichungstag der Anmeldung: **04.10.2001**
(21) Anmeldenummer: 01000069.3
(22) Anmeldetag: 23.03.2001
(51) Int. Cl.: H05K 7/20

(54) **Netz- oder Ladegerät**

(30) Priorität: 30.03.2000 DE 10015885
(71) Anmelder: Philips Corporate Intellectual Property GmbH, 52064 Aachen (DE); Koninklijke Philips Electronics N.V., 5621 BA Eindhoven (NL)
(72) Erfinder: Dürbaum, Thomas, Philips Corp. Intel.Prop.GmbH, 52064, Aachen (DE); Lürkens,Peter Dr., Philips Corp. Intel.Prop.GmbH, 52064, Aachen (DE); Halfmann, Jürgen, Philips Corp. Intel.Prop.GmbH, 52064, Aachen (DE)
(74) Vertreter: Volmer, Georg, Dipl.-Ing.

(57) **Zusammenfassung**

Die Erfindung betrifft ein Netz- oder Ladegerät (1). Das Gerät soll bei kompakter Bauweise während des Betriebs erzeugte Wärme gut an die Umgebung abgeben und andererseits möglichst handlich ist. Es wird vorgeschlagen, das Gehäuse (2) des Geräts mit Kühlrippen (4) zu versehen, wobei die Kühlrippen (2) so angeordnet sind, dass die Kühlrippenzwischenräume zur Fixierung eines Gerätekabels (5) geeignet sind.

## Beschreibung

Die Erfindung betrifft ein Netz- oder Ladegerät. Netzgeräte wandeln Ströme oder Spannungen von Energieversorgungsnetzen in für den Betrieb elektrischer Anlagen oder Geräte geeignete Ströme oder Spannungen um. Ladegeräte dienen zum Aufladen von Akkumulatoren, z. B. für Mobiltelefone, schnurlose Telefone oder portable Computer.

Das Gehäuse eines Netz- oder Ladegeräts wird üblicherweise aus Kunststoff gefertigt, was kostengünstig ist und eine elektrische Isolation gewährleistet. Ein in das Netz- oder Ladegerät einsteckbares Gerätekabel dient zur Herstellung einer Verbindung zum zu versorgenden Gerät bzw. Akkumulator.

Aus der US 5,016,139 ist ein Netzgerät bekannt, bei dem das Gehäuse aus zwei Teilen besteht und zumindest teilweise aus Metall oder Kunststoff gefertigt ist. Das Gehäuseoberteil enthält einen durch Stege gebildeten grillförmigen Teilbereich. Die Stege enden in der Ebene der Gehäuseoberseite und fußen in einem Basisbereich näherungsweise gleicher Dicke, der so geformt ist, dass er im zusammengebauten Netzgerät auf zwei Kondensatoren formschlüssig aufsitzt und diese in einer Aufnahmevorrichtung festhält. Der Basisbereich weist an der den Kondensatoren zugewandten Seite eine gut wärmeleitende Beschichtung auf, so dass im Betrieb des Netzgerätes von den Kondensatoren erzeugte Wärme gut an die Umgebung abgegeben wird.

Der Erfindung liegt die Aufgabe zugrunde, ein Netzgerät zu schaffen, das bei kompakter Bauweise während des Betriebs erzeugte Wärme gut an die Umgebung abgibt und andererseits möglichst handlich ist.

Die Aufgabe wird dadurch gelöst, dass das Netz- oder Ladegerät ein Kühlrippen aufweisendes Gehäuse hat, wobei die Kühlrippen so angeordnet sind, dass die Kühlrippenzwischenräume zur Fixierung eines Gerätekabels geeignet sind

Bei einer derartigen Geräteausgestaltung dienen die Kühlrippen nicht nur zur Kühlung des betreffenden Geräts, sondern zusätzlich auch zur Aufnahme eines Gerätekabels, das lösbar zwischen den Kühlrippen fixiert (eingeklemmt) werden kann, so dass eine kompakte handliche Einheit entsteht. Das Fixieren des Gerätekabels zwischen den Kühlrippen ist insbesondere für den Gerätetransport vorteilhaft, denn das Gerätekabel wird dann nicht als loses Teil transportiert und kann auch nicht als separates Teil verloren gehen. Es ist lediglich ein entsprechender Abstand der Kühlrippen zu gewährleisten. Weiterer zusätzlicher Materialaufwand ist nicht erforderlich.

Insbesondere wird das Gehäuse als Spritzgusskunststoffteil ausführt und kann so preisgünstig hergestellt werden, wobei die Formung der Kühlrippen kein Problem darstellt.

Um die Ableitung von Wärme an die Umgebung weiter zu verbessern, wird vorgeschlagen, dass auf der Innenseite des Gehäuses eine gut wärmeleitende Schicht aufgebracht ist. Eine starke Erwärmung des Gehäuses in kleinen Bereichen wird verhindert, wodurch auch gewährleistet werden kann, dass ein aus Kunststoff gefertigtes Gehäuse an keiner Stelle die zulässige Maximaltemperatur des Kunststoffs überschreitet. Die gut wärmeleitende Schicht ist beispielsweise eine Metallschicht, die sich leicht und preiswert auf die Innenseite des Gerätegehäuses aufbringen lässt. Als Nebeneffekt wird zuätzlich die Abstrahlung elektromagnetischer Strahlung an die Umgebung verringsrt, d.h. die EMV-Eigenschaften des Netz- oder Ladegeräts werden verbessert.

Alternativ oder zusätzlich zu einer gut wärmeleitenden innenseitigen Beschichtung des Gerätegehäuses können auf der Innenseite des Gehäuses Kühlrippen angeordnet werden, um die Ableitung von Wärme aus dem Gehäuseinneren an die Umgebung zu fördern.

In einer anderen Ausgestaltung ist vorgesehen, dass das Gehäuse auf der Innenseite Aussparungen aufweist. Diese sind zusätzlich oberflächenvergrößernd und fördern ebenfalls die Ableitung von Wärme an die Umgebung Sie sind an die im Inneren des Gehäuses anzuordnenden Gerätekomponenten anzupassen, d.h. diese sollten möglichst nah an der Gehäuseinnenseite angeordnet sein.

Ausführungsbeispiele der Erfindung werden nachstehen anhand der Zeichnungen näher erläutert. Es zeigen:
Fig 1 einer Vorderansicht eines Netz- oder Ladegeräts;
Fig 2 einen Schnitt durch einen Teil des Gerätegehäuses,
Fig 3 einen Schnitt durch einen Teil einer anderen Gerätegehäuseausgestaltung und
Fig. 4-6 weitere Gerätegehäuseausgestaltungen.

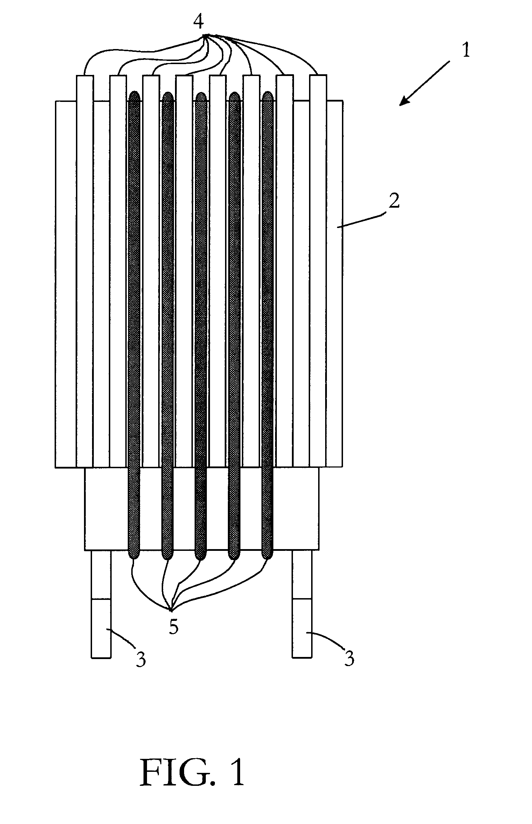

Fig 1 zeigt ein Netz- oder Ladegerät 1 mit einem Kunststoffgehäuse 2, das hier einstückig ausgebildet ist und bis auf freiliegende Netzsteckerkontakte 3 das gesamte Gerät 1 umschließt. Auf der Außenseite des Gerätegehäuses 2 sind zueinander parallel liegende Kühlrippen 4 angeformt. Das Gehäuse 2 wird einschließlich der Kühlrippen 4 als ein einziges Teil im Kunststoffspritzgussverfahren hergestellt. Zwischen den Kühlrippen 4 ist ein Gerätekabel 5 eingeklemmt. Das Kabel 5 ist um das Gehäuse 2 herum aufgewickelt. Die Kühlrippen 4 weisen zueinander einen solchen Abstand auf, dass das Gerätekabel 5 lösbar zwischen den Kühlrippen 4 fixiert werden kann. Der Abstand zwischen den Kühlrippen 4 ist soviel kleiner als der Durchmesser des Gerätekabels 5, dass dieses ohne Probleme in die Kühlrippenzwischenräume einführbar ist und darüber hinaus noch eine ausreichende Klemmkraft von den Kühlrippenseitenwänden auf das eingeführte (aufgewickelte) Gerätekabel 5 aufgeübt wird.

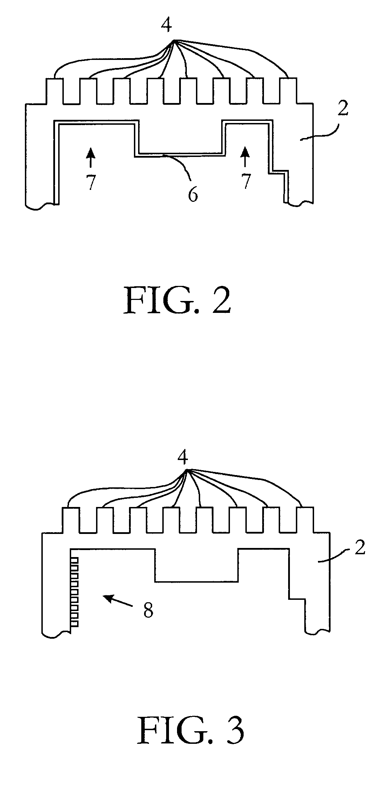

Die Fig. 2 zeigt einen Schnitt durch den oberen Bereich des Gehäuses 2 aus Fig. 1. Die Gehäuseinnenseite weist eine gut wärmeleitende - hier metallische - Beschichtung 6 auf, die zur Verbesserung der Wärmeableitung dient. Beispielhaft sind Aussparungen 7 dargestellt, die an die inneren (nicht dargestellten) Gerätekomponenten angepasst sind Die Aussparungen 7 vergrößern die Gehäuseinnenfläche, was die Wärmeableitung fördert, und dienen außerdem zur Fixierung der innen liegenden Gerätekomponenten.

Die Fig. 3 zeigt in einer Fig 2 entsprechenden Gehäuseschnittzeichnung auf der Innenseite des Gehäuses 2 angeordnete zusätzliche Kühlrippen 8, die zur Verbesserung der Ableitung von Wärme aus dem Geräteinneren an die Geräteumgebung dienen. Innen angeordnete Kühlrippen 8 und die Beschichtung 6 können sowohl getrennt als auch kombiniert eingesetzt werden.

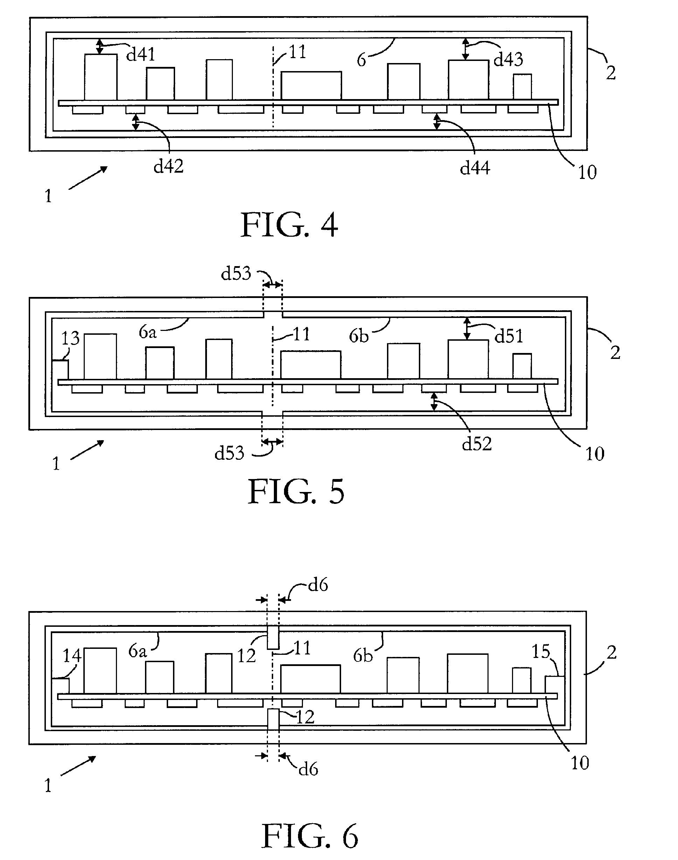

Die Fig. 4 bis 6 zeigen Schnitte durch das Gerät 1 mit verschiedenen Ausgestaltungsmöglichkeiten für die leitende Gehäusebeschichtung 6. Im Gehäuse 2 ist eine Leiterplatte 10 angeordnet, die elektrische Bauelemente trägt. Eine Anzahl dieser Bauelemente ist dargestellt, und zwar lediglich in schematischer Form (in Form von rechteckförmigen Blöcken), um deutlich zu machen, dass diese einen bestimmten Mindestabstand zur Beschichtung 6 aufweisen müssen. Eine gestrichelte Linie 11 dient zur Verdeutlichung, dass die elektrischen Bauelemente und Schaltkreise der Primärseite und der Sekundärseite räumlich wneinander gstrennt angeordnet sind. Links der Linie 11 liegen die Bauelemente der Primärseite, rechts der Linie 11 liegen die Bauelemente der Sekundärseite. Grundsätzlich haben die Bauelemente der Primärseite einen vorgegebenen Abstand zu den Bauelementen der Sekundärseite einzuhalten. Außerdem müssen Mindestabstände zwischen den Bauelementen der Leiterplatte und der Beschichtung 6 eingehalten werden, d. h. es sind bestimmte minimale Kriechstrecken ("creepage distance") einzuhalten, die üblicherweise durch Normen vorgegeben werden, z B. durch die IEC 60950 (vgl. Kapitel 2.10.4 bis 2.10.6 in der Ausgabe 1999-04).

In Fig. 4 ist die Beschichtung 6 durchgehend auf die Gehäuseinnenseite aufgebracht und ohne leitende Verbindung zur Leiterplatte 10 ("floatend"). Sowohl die Bauelemente der Primärseite als auch die Bauelemente der Sekundärseite haben bestimmte minimale Abstände zu Beschichtung 6 einzuhalten. Beispielhaft sind Abstände d41, d42, d43 und d44 eingezeichnet, die bestimmte Minimalwerte nicht unterschreiten dürfen.

Fig. 5 zeigt den Fall, dass die Beschichtung 6 aus zwei Teilflächen 6a und 6b besteht, die einen Abstand d53 aufweisen und die Primärseite bzw. die Sekundäiseite umgreifen. Die Teilfläche 6a ist mit dem Massepotential der Primärseite verbunden (Verbindung 13). Dies führt dazu, dass lediglich für die Bauelemente der Sekundärseite (siehe beispielsweise Abstände d51 und d52) eine minimale Kriechstrecke zur Beschichtung 6 (d.h. zur Teilfläche 6b) einzuhalten ist. Weiterhin ist eine minimale Kriechstrecke zwischen den Teilflächen 6a und 6b einzuhalten, d.h. der eingezeichnete Abstand d53 muss einen bestimmten Minimalwert überschreiten.
Bei der in Fig. 6 gezeigten Ausführungsvariante besteht die Beschichtung 6 wie in Fig. 5 aus zwei Teilflächen 6a und 6b, zwischen denen aber hier eine nicht elektrisch leitende Rippe 12 angeordnet ist, was dazu führt, dass der mit d6 bezeichnete Abstand zwischen den Teilflächen 6a und 6b kleiner als Abstand ohne Rippe (wie in Fig. 5) sein kann. In Fig. 6 ist die Teilfläche 6a mit dem Massepotential der Primärseite (Verbindung 14) und Teilfläche 6b mit dem Massepotential der Sekundärseite (Verbindung 15) verbunden, so dass lediglich für den Abstand d6 ein Kriechstreckenminimalwert gilt.

Die in Fig. 4 bis 6 angedeuteten Ausgestaltungsmöglichkeiten sollen die Vielzahl möglicher Ausgestaltungen der Innenbeschichtung 6 andeuten. Weitere Kombinationen und Varianten sind selbstverständlich möglich. So kann in Fig. 4 die Beschichtung 6 auch mit dem Massepotential der Primär- oder der Sekundärseite verbunden werden. In Fig 5 könnte anstelle oder zusätzlich zur Verbindung der Teilfläche 6a mit dem primärseitigen Massepotential eine Verbindung der Teilfläche 6b mit dem sekundärseitigen Massepotential vorgenommen werden. Die sich so im Zusammenhang mit Fig. 5 ergebenden Varianten lassen sich selbstverständlich auch auf die Ausführung gemäß Fig. 6 übertragen.

## Patentansprüche

1. Netz- oder Ladegerät mit einem Kühlrippen (4) aufweisenden Gehäuse (2), wobei die Kühlrippen (2) so angeordnet sind, dass die Kühlrippenzwischenräume zur Fixierung eines Gerätekabels (5) geeignet sind.

2. Netz- oder Ladegerät nach Anspruch 1,
**dadurch gekennzeichnet,**
**dass** das Gehäuse (2) als Spritzgusskunststoffteil ausgeführt ist.

3. Netz- oder Ladegerät nach Anspruch 1 oder 2,
**dadurch gekennzeichnet,**
**dass** auf der Innenseite des Gehäuses (2) eine gut wärmeleitende Schicht (6) aufgebracht ist.

4. Netz- oder Ladegerät nach einem der Ansprüche 1 bis 3,
**dadurch gekennzeichnet,**
**dass** auf der Innenseite des Gehäuses (2) Kühlrippen (8) angeordnet sind

5. Netz- oder Ladegerät nach einem der Ansprüche 1 bis 4,
**dadurch gekennzeichnet,**
**dass** das Gehäuse (2) auf der Innenseite Aussparungen (7) aufweist.
